# EUROPÄISCHE PATENTSCHRIFT

(11) **EP 1 438 720 B1**
(45) Veröffentlichungstag und Bekanntmachung des Hinweises auf die Patenterteilung: **16.04.2008**
(21) Anmeldenummer: 02774448.1
(22) Anmeldetag: 09.10.2002
(51) Int. Cl.: G11C 5/14, G11C 11/16

(54) **SPEICHERANORDNUNG**
STORAGE ASSEMBLY
SYSTEME DE MEMOIRE

(30) Priorität: 23.10.2001 DE 10152034
(43) Veröffentlichungstag der Anmeldung: 21.07.2004
(73) Patentinhaber: Qimonda AG, 81739 München (DE)
(72) Erfinder: BANGERT, Joachim, 91052 Erlangen (DE)
(74) Vertreter: Müller - Hoffmann & Partner
(86) Internationale Anmeldenummer: PCT/DE2002/003812
(87) Internationale Veröffentlichungsnummer: WO 2003/038829

(56) Entgegenhaltungen:
- US-A- 4 404 502
- US-B1- 6 265 846
- "RESONANT POWER SUPPLY FOR HOT-CLOCK REVERSIBLE LOW POWER COMPUTING" IBM TECHNICAL DISCLOSURE BULLETIN, IBM CORP. NEW YORK, US, Bd. 37, Nr. 7, 1. Juli 1994 (1994-07-01), Seiten 147-150, XP000455468 ISSN: 0018-8689

## Beschreibung

Die vorliegende Erfindung betrifft eine Speicheranordnung mit mindestens einem Speicherzellenfeld, in dem eine Vielzahl von Speicherzellen mit Bitleitungen und Wortleitungen verbunden ist, und mit wenigstens einer Generatoreinrichtung, die zum Schreiben und/oder Auslesen mindestens einer Speicherzelle wenigstens in dieser einen Speicherzelle zugeordnete Bit- und/oder Wortleitungen einen Strom einzuspeisen vermag. Bei dieser Anordnung handelt es sich in bevorzugter Weise um eine MRAM-Anordnung (MRAM = Magnetoresistive Random Access Memory bzw. magnetoresistiver Schreib/Lesespeicher).

Das Schreiben von Informationen in Speicherzellen, insbesondere MRAM-Speicherzellen, erfolgt durch elektrische Ströme, die von einer Konstantstromquelle gegen ein festes Potential, wie insbesondere Masse, fließen. Diese Ströme bewirken abhängig von ihrer Richtung eine parallele oder antiparallele Orientierung der Polarisation von durch eine Tunnelbarrierenschicht getrennten magnetoresistiven Schichten der einzelnen Speicherzellen der MRAM-Anordnung. Einer parallelen Orientierung der Polarisation ist dabei bekanntlich ein niedrigerer Widerstandswert als einer antiparallelen Orientierung der Polarisation zugeordnet. Als Schreibströme werden Pulse eingesetzt, wobei für den Schreibvorgang die Pulsamplitude und nicht die Pulsdauer entscheidend ist.

Bei einem Schreibvorgang in eine selektierte Speicherzelle an der Kreuzung zwischen einer bestimmten Wortleitung und einer bestimmten Bitleitung wird dabei neben magnetischer Energie auch durch den Spannungsabfall an den Leitungswiderständen der Wortleitung bzw. Bitleitung elektrische Energie in Wärmeenergie umgesetzt und damit verbraucht. Insgesamt ist dabei die Energiebilanz sogar äußerst ungünstig, da tatsächlich ein Großteil der elektrischen Energie in Wärme übergeht.

Neben diesem Energieverlust ist zu beachten, dass für verschieden große Speicherzellenfelder in Speicheranordnungen Maßnahmen getroffen werden müssen, um die Spannungsabfälle über den einzelnen Speicherzellen der unterschiedlich großen Speicherzellenfelder gleichmäßig zu halten.

Auch beim Auslesen einer Speicherzelle fließt ein die gespeicherte Information angebender Stromimpuls, der bei einem niedrigeren Widerstandswert (parallele Orientierung der Polarisation) eine größere Amplitude als bei einem höheren Widerstandswert (antiparallele Orientierung der Polarisation) hat und somit einen Zellinhalt als "1" bzw. "0" wiederzugeben vermag. Ein solcher Stromimpuls ruft ähnlich wie ein Schreibstrom einen Energieverlust in der Form von Wärme hervor.

Im folgenden soll dieses Schreiben und Lesen einer Speicherzelle in einem Speicherzellenfeld der Speicheranordnung auch als "Ansteuern" oder "Setzen" bezeichnet werden.

Bisher wurde die obige Problematik der Verlustenergie wenig beachtet und allenfalls wie folgt einer Lösung nähergebracht:

Bekanntlich wird der Leiterbahnwiderstand einer Wortleitung bzw. Bitleitung oder auch einer zusätzlichen Schreibleitung durch die spezifische Leitfähigkeit des Materials der Leiterbahn, deren Querschnittsfläche und deren Länge bestimmt. Um also in einer Speicheranordnung zu starke Spannungsabfälle an Speicherzellen zu vermeiden und so die Gefahr von elektrischen Durchbrüchen zu vermindern, werden die Leiterbahnen möglichst niederohmig ausgelegt, und die nach einem Setzen verbleibende restliche Spannung wird in nachgeschalteten Widerständen "verbrannt". Mit anderen Worten, Verluste in den Leiterbahnen und insbesondere in den nachgeschalteten Widerständen werden also bewusst in Kauf genommen. Dies bedeutet aber, dass bei solchen bestehenden Speicheranordnungen die Energiebilanz sehr ungünstig ist.

Es ist daher Aufgabe der vorliegenden Erfindung, eine Speicheranordnung der eingangs genannten Art zu schaffen, bei der Energieverluste minimiert sind, so dass eine verbesserte Energiebilanz erhalten wird.

Diese Aufgabe wird bei einer Speicheranordnung der eingangs genannten Art erfindungsgemäß dadurch gelöst, dass die Generatoreinrichtung als ein Energiespeichersystem ausgebildet ist, das beim Ansteuern (bzw. Setzen) der mindestens einen Speicherzelle die durch den dabei fließenden Strom entstehende Energie sammelt, so dass diese für folgendes Ansteuern weiterer Speicherzellen zur Verfügung steht.

Vorteilhafte Weiterbildungen der Erfindung ergeben sich aus den Unteransprüchen.

Bei der erfindungsgemäßen Speicheranordnung mit mindestens einem Speicherzellenfeld, in welchem eine Vielzahl von Speicherzellen mit Bitleitungen und Wortleitungen und gegebenenfalls zusätzlichen Schreibleitungen verbunden ist, enthält also das Speicherzellenfeld wenigstens eine Generatoreinrichtung, die als Energiespeichersystem ausgebildet ist, das die bei einem Setzvorgang (insbesondere einem Schreibvorgang) wenigstens einer Speicherzelle freigesetzte Energie sammelt, so dass diese nicht in einem Widerstand "verbrannt" wird, sondern vielmehr für folgende Setzvorgänge, also anschließende Schreib- bzw. Lesevorgänge, zur Verfügung steht.

Die Generatoreinrichtung kann aus vier Generatoreinheiten bestehen, von denen jeweils eine an einer Seite des Speicherzellenfeldes gelegen und mit den Wortleitungen bzw. Bitleitungen jeweils über Multiplexer verbunden ist.

Die Generatoreinheiten können dabei takt- oder impulsgesteuert umschaltbar sein und somit als takt- bzw. impulsgesteuerte Ladungsquellen dienen. Für das takt- bzw. impulsgesteuerte Umschalten werden vorzugsweise Transistoren eingesetzt.

Die Generatoreinheiten weisen jeweils Energiespeichereinheiten auf, für die beliebige Kombinationen von Kondensatoren, Induktivitäten oder auch andere Speicherbauarten eingesetzt werden können. Solche Bauarten können insbesondere neuartige Energiespeicher, wie Speicher für Spins in Halbleitern oder Reflektoren für Spinwellen, sein. Speicher für Spins nutzen die Tatsache aus, dass Spins sich sehr lange erhalten können, und werden als aussichtsreiche magnetoelektronide Bauelemente angesehen. Besonders vorteilhaft ist aber die Verwendung von Kondensatoren in Energiespeichereinheiten, da diese ohne weiteres integriert und auf einfache Weise realisiert werden können.

Werden Kondensatoren in den Energiespeichereinheiten eingesetzt, so können diese Kondensatoren durch takt- bzw. impulsgesteuertes Umschalten wenigstens eines Schalterpaares von einer Parallelschaltung aus mindestens zwei Kondensatoren in eine Serienschaltung aus diesen beiden Kondensatoren umgeschaltet werden. Liegt beispielsweise an einem Ende einer Bitleitung eine Serienschaltung von zwei Kondensatoren und am anderen Ende derselben Bitleitung eine Parallelschaltung von zwei entsprechenden Kondensatoren, so fließt ein Schreibstrom von dem einen Ende der Bitleitung zum anderen Ende der Bitleitung über die jeweiligen Auswahlbausistoren. Wird sodann die Serienschaltung am einen Ende der Bitleitung in eine Parallelschaltung der beiden Kondensatoren umgeschaltet und wird die Parallelschaltung der beiden Kondensatoren am anderen Ende der Bitleitung in eine Serienschaltung dieser beiden Kondensatoren geschaltet, so ist die Anordnung bereit, wieder einen Strompuls zu generieren.

In vorteilhafter Weise können bei der erfindungsgemäßen Speicheranordnung noch zusätzliche Ausgleichsenergiespeicher vorgesehen werden, die in ähnlicher Weise wie die Energiespeichereinheiten aufgebaut sind und nach einem Setzvorgang wenigstens einer Speicherzelle entstehende Energieverluste auszugleichen vermögen. Diese zusätzlichen Ausgleichsenergiespeicher sind über die jeweiligen Multiplexer mit Wortleitungen bzw. Bitleitungen verbindbar, so dass gegebenenfalls auftretende Energieverluste durch Zuschalten dieser Ausgleichsenergiespeicher ausgeglichen werden können.

Die Ausgleichsenergiespeicher bestehen ebenfalls wie die Energiespeichereinheiten in bevorzugter Weise aus Kondensatoren.

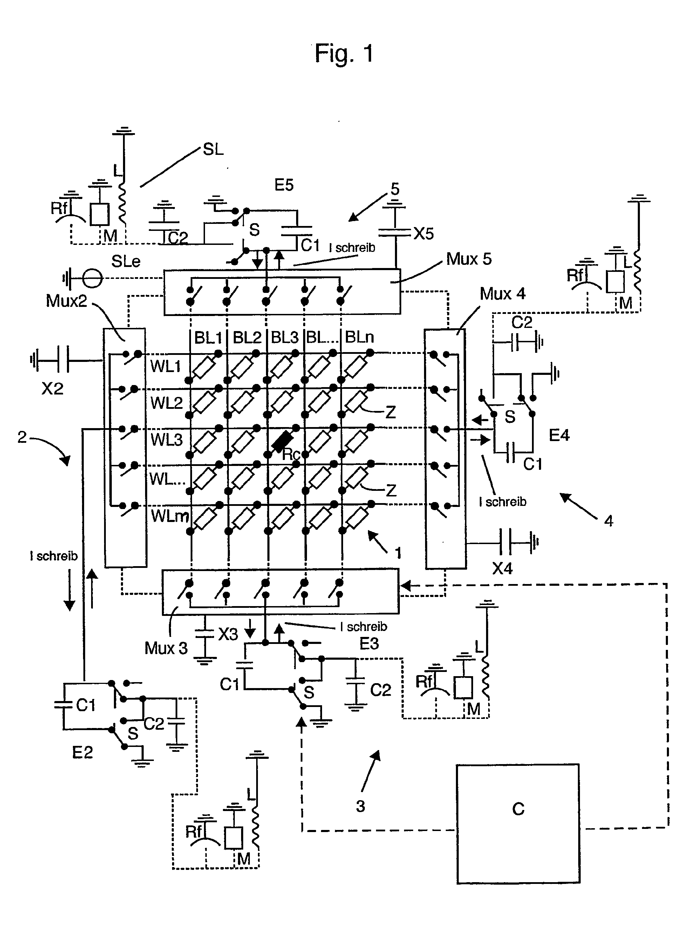

Nachfolgend wird die Erfindung anhand der Zeichnung näher erläutert, in deren einziger Figur ein Ausführungsbeispiel der Speicheranordnung in verschiedenen Varianten dargestellt ist.

Die einzige Figur zeigt ein Speicherzellenfeld 1 aus einer Vielzahl von MRAM-Speicherzellen Z, die jeweils symbolisch als Widerstand Rc wiedergegeben sind. Die einzelnen Speicherzellen bzw. Widerstände Rc bestehen dabei aus sogenannten MTJ-Schichtfolgen, bei denen eine Tunnelschicht zwischen zwei magnetoresistiven Schichten gelegen ist (MTJ = Magnetic Tunnel Junction).

Jeder einzelne Widerstand Rc liegt zwischen einer Wortleitung WL und einer Bitleitung BL. Im Speicherzellenfeld 1 sind m Wortleitungen WL und n Bitleitungen BL vorgesehen. Eine selektierte Zelle Z, die durch einen schwarz ausgefüllten Widerstand Rc wiedergegeben ist, liegt beispielsweise zwischen der Wortleitung WL3 und der Bitleitung BL3. Die Zelle Z wird selektiert, indem die Wortleitung WL3 und die Bitleitung BL3 mit einer bestimmten Spannungsdifferenz beaufschlagt werden.

Auf jeder Seite des Speicherzellenfeldes 1 ist eine Generatoreinrichtung in der Form eines Energiespeichersystems 2, 3, 4, 5 vorgesehen. Diese Energiespeichersysteme 2, 3, 4, 5 bestehen jeweils aus einer Energiespeichereinheit E2, E3, E4 bzw. E5 und aus einem Multiplexer Mux2, Mux3, Mux4 und Mux5.

Auf diese Weise ist also beispielsweise das Energiespeichersystem 2 aus der Energiespeichereinheit E2 und dem Multiplexer Mux2 aufgebaut.

Jede Energiespeichereinheit E2 bis E5 besteht aus Kondensatoren C1, C2, die über ein Schalterpaar S aus einer Serienschaltung in eine Parallelschaltung umgewandelt werden können. Die Energiespeichereinheit E2 weist dabei eine Parallelschaltung der Kondensatoren C1 und C2 auf, während die Energiespeichereinheit E4, die über die Wortleitungen WL1 bis WLm mit der Energiespeichereinheit E2 verbunden ist, eine Serienschaltung der entsprechenden Kondensatoren C1, C2 hat. Entsprechend liegen die Kondensatoren C1, C2 der Energiespeichereinheit E3 mittels des Schalterpaares S in einer Parallelschaltung und die Kondensatoren C1, C2 der über die Bitleitungen BL1 bis BLn mit der Energiespeichereinheit E3 verbundenen Energiespeichereinheit E5 in einer Serienschaltung vor. Mit anderen Worten, die Wortleitungen WL bzw. die Bitleitungen BL sind an ihren einander gegenüberliegenden Enden jeweils mit einer Energiespeichereinheit versehen, wobei am einen Ende Kondensatoren in Serienschaltung und am gegenüberliegenden Ende Kondensatoren in Parallelschaltung geschaltet sind. Die Schalter S, die in bevorzugter Weise aus Transistoren, wie insbesondere MOS-Transistoren bestehen, können von einer zentralen Steuereinheit C angesteuert sein, wie dies schematisch für das Schalterpaar S der Energiespeichereinheit E3 angedeutet ist.

Die Serienschaltung der Kondensatoren C1 und C2 und deren Parallelschaltung ist an den nicht mit den jeweiligen Multiplexern verbundenen Ende auf festes Potential, beispielsweise Masse, gelegt.

Die Energiespeichereinheiten E1 bis E5 können anstelle von Kondensatoren auch andere Energiespeicher aufweisen, wie beispielsweise Speicher M für Spins und Reflektoren Rf für Spinwellen oder Induktivitäten L. Bevorzugt werden jedoch aus Kondensatoren aufgebaute Energiespeichereinheiten verwendet. Selbstverständlich können dabei auch mehr als zwei Kondensatoren jeweils in einer Parallelschaltung oder einer Serienschaltung liegen.

Die Multiplexer Mux1 bis Mux4 können noch jeweils mit einem Ausgleichsenergiespeicher x2, x3, x4 und x5 versehen sein, der eventuell auftretende Energieverluste auszugleichen vermag und durch den entsprechenden Multiplexer, gesteuert durch die Steuereinheit C, zugeschaltet werden kann. Anstelle eines solchen Ausgleichsenergiespeichers x2 bis x5 kann gegebenenfalls auch eine spannungsführende Leitung SL vorgesehen sein, wie dies beispielhaft für den Multiplexer Mux5 gezeigt ist.

Bekanntlich wird das Schreiben von Informationen in beispielsweise MRAM-Speicherzellen Z durch elektrische Ströme gelöst. Dabei fließen gewöhnlich Ströme von einer Konstantstromquelle gegen Masse, wobei die eingangs erwähnten Verluste auftreten, so dass die Energiebilanz insgesamt ungünstig ist.

Bei der erfindungsgemäßen Speicheranordnung bestehen die Leiterbahnen der Wortleitungen und Bitleitungen aus einem Material mit einem möglichst geringen Bahnwiderstand, so dass an sich vergleichsweise wenige elektrische Energie in Wärme umgesetzt wird. Dies ist selbstverständlich auch das Bemühen beim Stand der Technik.

Wesentlich an der vorliegenden Erfindung ist nun aber, dass die fließende elektrische Energie, die beispielsweise von der Energiespeichereinheit E5 und von der Energiespeichereinheit E4 abgegeben wird, nicht wie beim Stand der Technik in Widerständen "verbrannt" wird, sondern vielmehr in den Energiespeichereinheiten E3 und E2 gespeichert werden kann. Mit anderen Worten, die Energiespeichereinheiten E4 und E5 mit den Serienschaltungen der Kondensatoren C1, C2 wirken als Quelle eines Schreibstromes Ischreib, der von diesen Energiespeichereinheiten E4, E5 in die Energiespeichereinheiten E2 bzw. E3 fließt und dort von den in Parallelschaltung liegenden Kondensatoren C1, C2 aufgenommen und gespeichert wird.

Es liegen hier also Quellen von elektrischen Ladungen vor, die sich über die Leiterbahnen der Wortleitungen bzw. Bitleitungen in entsprechende Energiespeichereinheiten entladen, wobei diese Quellen durch die Serienschaltungen der Kondensatoren gebildet werden, während die Energiespeicher aus den Parallelschaltungen entsprechender Kondensatoren bestehen. Der Transport der Ladungen ist mit einem Magnetfeld verknüpft, mit dem in üblicher Weise die MRAM-Speicherzellen geschaltet werden können. Im dargestellten Ausführungsbeispiel sind über die Multiplexer Mux2 bis Mux5 jeweils die Wortleitung WL3 und die Bitleitung BL3 angesteuert, so dass ein entsprechender Schreibstrom durch diese Leitungen zu der Speicherzelle Z fließt, der durch den schwarz ausgefüllten Widerstand Rc symbolisiert ist.

Die Multiplexer Mux2 bis Mux5 können jeweils von der zentralen Steuereinheit C takt- und impulsgesteuert umgeschaltet werden, so dass insgesamt nicht mehr Quellen und Senken an Ladungen benötigt werden, als bisher in bestehenden Speicheranordnungen Konstantspannungsquellen und Serienwiderstände erforderlich sind.

Die Serienschaltung der Kondensatoren C1, C2 ist als Ladungsquelle anzusehen, da sie die doppelte Spannung der Einzelkondensatoren an ihrem Ausgang hat, während eine Parallelschaltung dieser Kondensatoren nur die einfache Spannung liefert. Werden also die beiden Schaltungen, also eine Serienschaltung und eine Parallelschaltung an gegenüberliegenden Enden der Wortleitungen bzw. Bitleitungen miteinander verknüpft, so fließt ein Ladungsausgleichsstrom von der Serienschaltung in die Parallelschaltung. Mittels des Schalterpaares oder einer anderen geeigneten Einrichtung kann die Serienschaltung in eine Parallelschaltung umgewandelt werden, so dass aus einer Quelle eine Senke und umgekehrt wird. Es findet damit ein Ladungsausgleich in der jeweiligen Gegenrichtung statt.

Gegebenenfalls können die Multiplexer Mux2 bis Mux5 auch so gestaltet und untereinander verbunden sein, dass Ströme durch die Leiterbahnen der Wortleitungen und Bitleitungen immer in gleicher Richtung fließen.

Der Ausgleichsenergiespeicher in der Form der Zusatzkondensatoren x2 bis x5 ist vorgesehen, um nach dem Schreiben Energieverluste infolge des Magnetfeldes und des Leiterbahnwiderstandes bei der jeweiligen Parallelschaltung auszugleichen. Mit anderen Worten, wenn beispielsweise ein Schreibstrom Ischreib von der Energiespeichereinheit E5 zur Energiespeichereinheit E3 fließt, so wird der dabei auftretende Verlust durch den Zusatzkondensator x3 ausgeglichen. Anstelle eines solchen Zusatzkondensators kann gegebenenfalls auch die spannungsführende Leitung SLe herangezogen werden.

Im obigen Ausführungsbeispiel bestehen die Energiespeichereinheiten aus Kondensatoren. Selbstverständlich können hierfür auch andere geeignete Energiespeicher verwendet werden, wie dies bereits erwähnt wurde und in der Zeichnung schematisch mit dem Spinspeicher M, dem Spinreflektor Rf und der Spule L angedeutet ist.

Die erfindungsgemäße Speicheranordnung kommt bevorzugt bei einem MRAM zur Anwendung. Sie kann aber auch bei anderen Speichertypen eingesetzt werden.

Auch ist es nicht erforderlich, dass an jeder Seite eines Speicherzellenfeldes eine Energiespeichereinheit mit einem Multiplexer vorgesehen wird. Es ist vielmehr auch möglich, beispielsweise nur die Wortleitungen oder nur die Bitleitungen mit entsprechenden Energiespeichereinheiten und Multiplexern auszustatten.

Die Multiplexer selbst müssen so ausgestaltet sein, dass sie die Ansteuerung einer zu einer selektierten Speicherzelle gehörenden Wortleitung bzw. Bitleitung erlauben, so dass der Stromstrom Ischreib nur durch die jeweilige entsprechende Wortleitung bzw. Bitleitung fließt. Entsprechendes gilt für einen Lesevorgang.

### Bezugszeichenliste

- 1: Speicherzellenfeld
- 2 - 5: Generatoreinrichtungen
- Mux2 - Mux5: Multiplexer
- E2 - E5: Energiespeichereinheiten
- S: Schalterpaar
- C1, C2: Kondensatoren
- M: Speicher für Spins
- Rf: Reflektor für Spinwellen
- C: zentrale Steuereinheit
- L: Induktivität
- SLe: spannungführende Leitung
- WL1 - WLm: Wortleitungen
- BL1 - BLn: Bitleitungen
- x2 - x5: Ausgleichsenergiespeicher
- Ischreib: Schreibstrom

## Patentansprüche

1. Speicheranordnung mit mindestens einem Speicherzellenfeld (1), in dem eine Vielzahl von Speicherzellen (Z) mit Bitleitungen (BL1, ..., BLn) und Wortleitungen (WL1, ..., WLm) verbunden ist, und mit mindestens einer Generatoreinrichtung (2 bis 5), die zum Schreiben und/oder Auslesen mindestens einer Speicherzelle (Z) wenigstens in die dieser einen Speicherzelle (Z) zugeordneten Bit- und/oder Wortleitungen ein Strom einzuspeisen vermag,
**dadurch gekennzeichnet,**
**dass** die Generatoreinrichtung (2, 5) als Energiespeichersystem (E2 bis E5) ausgebildet ist, das beim Ansteuern der wenigstens einen Speicherzelle (Z) die durch den dabei fließenden Strom transportierte Energie sammelt, so dass diese für folgendes Ansteuern weiterer Speicherzellen zur Verfügung steht.

2. Speicheranordnung nach Anspruch 1,
**dadurch gekennzeichnet,**
**dass** das Energiespeichersystem (E2 bis E5) zwischen einem Energieaufnahmezustand und einem Energieabgabezustand taktgesteuert umschaltbar ist.

3. Speicheranordnung nach Anspruch 1 oder 2,
**dadurch gekennzeichnet,**
**dass** das Energiespeichersystem aus Energiespeichereinheiten (E2 bis E5) besteht, die jeweils an wenigstens einer Seite des Speicherzellenfeldes (1) angeordnet sind.

4. Speicheranordnung nach Anspruch 3,
**dadurch gekennzeichnet,**
**dass** die Energiespeichereinheit (E2 bis E5) aus Kondensatoren (C1, C2) und/oder Induktivitäten (L) aufgebaut ist.

5. Speicheranordnung nach Anspruch 3,
**dadurch gekennzeichnet,**
**dass** die Energiespeichereinheit aus Speichern (M) für Spins in Halbleitern und Reflektoren (Rf) für Spinwellen aufgebaut ist.

6. Speicheranordnung nach Anspruch 4,
**dadurch gekennzeichnet,**
**dass** die Kondensatoren (C1, C2) mit einer Schaltereinrichtung (S) verbunden und von einer Parallelschaltung von wenigstens zwei Kondensatoren (C1, C2) in eine Serienschaltung von diesen und umgekehrt umschaltbar sind.

7. Speicheranordnung nach einem der Ansprüche 1 bis 6,
**dadurch gekennzeichnet,**
**dass** das Energiespeichersystem über Multiplexer (Mux2 bis Mux5) mit dem Speicherzellenfeld (1) verbunden ist.

8. Speicheranordnung nach einem der Ansprüche 1 bis 7,
**dadurch gekennzeichnet,**
**dass** wenigstens ein weiterer Ausgleichsenergiespeicher (x) oder wenigstens eine spannungsführende Leitung (SLe) vorgesehen ist, der bzw. die vor, während und nach einem Schreiben bzw. Lesen einer Speicherzelle (Z) entstehende Energieverluste ausgleicht.

9. Speicheranordnung nach Anspruch 8,
**dadurch gekennzeichnet,**
**dass** der Ausgleichsenergiespeicher (x) aus wenigstens einem Kondensator und/oder wenigstens einer Induktivität aufgebaut ist.

10. Speicheranordnung nach Anspruch 8,
**dadurch gekennzeichnet,**
**dass** der Ausgleichsenergiespeicher (x) aus wenigstens einem Speicher für Spins in Halbleitern und wenigstens einem Reflektor für Spinwellen aufgebaut ist.

11. Speicheranordnung nach einem der Ansprüche 1 bis 10,
**dadurch gekennzeichnet,**
**dass** das Speicherzellenfeld (1) durch ein MRAM-Feld gebildet ist.

## Claims

1. Memory arrangement having at least one memory cell array (1), in which a multiplicity of memory cells (Z) are connected to bit lines (BL1, ..., BLn) and word lines (WL1, ..., WLm), and having at least one generator device (2 to 5), which, for writing to and/or reading from at least one memory cell (Z), can feed a current at least into the bit and/or word lines assigned to this one memory cell (Z),
**characterized**
**in that** the generator device (2, 5) is designed as an energy storage system (E2 to E5) which, when the at least one memory cell (Z) is addressed, collects the energy transported by the current flowing in the process, so that said energy is available for subsequent addressing of further memory cells.

2. Memory arrangement according to Claim 1,
**characterized**
**in that** the energy storage system (E2 to E5) can be changed over between an energy take-up state and an energy release state in a clock-controlled manner.

3. Memory arrangement according to Claim 1 or 2,
**characterized**
**in that** the energy storage system comprises energy storage units (E2 to E5) each arranged at at least one side of the memory cell array (1).

4. Memory arrangement according to Claim 3,
**characterized**
**in that** the energy storage unit (E2 to E5) is constructed from capacitors (C1, C2) and/or inductances (L).

5. Memory arrangement according to Claim 3,
**characterized**
**in that** the energy storage unit is constructed from memories (M) for spins in semiconductors and reflectors (Rf) for spin waves.

6. Memory arrangement according to Claim 4,
**characterized**
**in that** the capacitors (C1, C2) are connected to a switch device (S) and can be changed over from a parallel circuit of at least two capacitors (C1, C2) into a series circuit thereof, and vice versa.

7. Memory arrangement according to one of Claims 1 to 6,
**characterized**
**in that** the energy storage system is connected to the memory cell array (1) via multiplexers (Mux2 to Mux5).

8. Memory arrangement according to one of Claims 1 to 7,
**characterized**
**in that** at least one further compensation energy store (x) or at least one voltage-carrying line (SLe) is provided, which compensates for energy losses arising before, during and after writing to or reading from a memory cell (Z).

9. Memory arrangement according to Claim 8,
**characterized**
**in that** the compensation energy store (x) is constructed from at least one capacitor and/or at least one inductance.

10. Memory arrangement according to Claim 8,
**characterized**
**in that** the compensation energy store (x) is constructed from at least one memory for spins in semiconductors and at least one reflector for spin waves.

11. Memory arrangement according to one of Claims 1 to 10,
**characterized**
**in that** the memory cell array (1) is formed by an MRAM array.

## Revendications

1. Dispositif de mémoire ayant au moins un champ (1) de cellules de mémoire, dans lequel une pluralité de cellules (Z) de mémoire est reliée à des lignes (BL1, ..., BLn) de bit et a des lignes (WL1, ..., WLm) de mot et ayant au moins un dispositif (2 à 5) de générateur qui permet d'injecter, pour l'écriture et/ou la lecture d'au moins une cellule (Z) de mémoire, un courant au moins dans les lignes de bit et/ou de mot associées à cette cellule (Z) de mémoire,
**caractérisé**
**en ce que** le dispositif (2, 5) de générateur est sous la forme d'un système (E2 à E5) d'accumulation d'énergie qui, lors de la commande d'au moins une cellule (Z) de mémoire, accumule l'énergie transportée par le courant qui passe de sorte que celle-ci soit disponible pour commander ensuite d'autres cellules de mémoire.

2. Dispositif de mémoire suivant la revendication 1,
**caractérisé**
**en ce que** le système (E2 à E5) d'accumulation d'énergie peut être commuté en étant commandé de manière cadencée entre un état d'absorption d'énergie et un état de cession d'énergie.

3. Dispositif de mémoire suivant la revendication 1 ou 2,
**caractérisé**
**en ce que** le système d'accumulation d'énergie est constitué d'unités (E2 à E5) d'accumulation d'énergie disposées respectivement sur au moins un côté du champ (1) de cellules de mémoire.

4. Dispositif de mémoire suivant la revendication 3,
**caractérisé**
**en ce que** les unités (E2 à E5) d'accumulation d'énergie sont constituées de condensateurs (C1, C2) et/ou d'inductances (L).

5. Dispositif de mémoire suivant la revendication 3,
**caractérisé**
**en ce que** l'unité d'accumulation d'énergie est constituée d'accumulateurs (M) de spin de semi-conducteurs et de réflecteurs (Rf) d'ondes de spin.

6. Dispositif de mémoire suivant la revendication 4,
**caractérisé**
**en ce que** les condensateurs (C1, C2) sont reliés à un dispositif (S) de commutateur et peuvent être commutés d'un circuit parallèle d'au moins deux condensateurs (C1, C2) à un circuit série de ceux-ci et inversement.

7. Dispositif de mémoire suivant l'une des revendications 1 à 6,
**caractérisé**
**en ce que** le système d'accumulation d'énergie est relié au champ (1) de cellules de mémoire par des multiplexeurs (Mux2 à Mux5).

8. Dispositif de mémoire suivant l'une des revendications 1 à 7,
**caractérisé**
**en ce qu'**il est prévu au moins un autre accumulateur (x) d'énergie de compensation ou au moins une ligne (SLe) d'application d'une tension, qui compense les pertes d'énergie créées avant, pendant et après une écriture ou une lecture d'une cellule (Z) de mémoire.

9. Dispositif de mémoire suivant la revendication 8,
**caractérisé**
**en ce que** l'accumulateur (x) d'énergie de compensation est formé d'au moins un condensateur et/ou d'au moins une inductance.

10. Dispositif de mémoire suivant la revendication 8,
**caractérisé**
**en ce que** l'accumulateur (x) d'énergie de compensation est formé d'au moins un accumulateur de spin de semi-conducteurs et d'au moins un réflecteur d'ondes de spin.

11. Dispositif de mémoire suivant l'une des revendications 1 à 10,
**caractérisé**
**en ce que** le champ (1) de cellules de mémoire est formé d'un champ MRAM.
